Europäisches Patentamt

European Patent Office

Office européen des brevets

(19)

(11) Numéro de publication: **0 100 261**
**B1**

(12) **FASCICULE DE BREVET EUROPEEN**

(45) Date de publication du fascicule du brevet: **01.06.88**

(51) Int. Cl.⁴: **H 05 K 7/20,** H 01 L 23/46

(21) Numéro de dépôt: **83401407.8**

(22) Date de dépôt: **07.07.83**

(54) **Dispositif de refroidissement par convection naturelle de composants électroniques ou de composants électriques et électroniques, et appareil utilisant un tel dispositif.**

(30) Priorité: **12.07.82 FR 8212207**

(43) Date de publication de la demande:
**08.02.84 Bulletin 84/06**

(45) Mention de la délivrance du brevet:
**01.06.88 Bulletin 88/22**

(84) Etats contractants désignés:
**DE FR GB IT**

(56) Documents cités:
**FR-A-1 129 919**
**US-A-2 933 655**

**MACHINE DESIGN, vol. 29, no. 9, 2 mai 1957,
pages 84-93, Penton, USA T.C. REEVES:
"Thermal design in electronic equipment"
IRE TRANSACTIONS ON AERONAUTICAL AND
NAVIGATIONAL ELECTRONICS, vol. 5, no. 4,
mars 1958, pages 4-9, New York, USA J. KAYE
et al.: "General aspects of cooling airborne
electronic equipment"**

(73) Titulaire: **BULL S.A.
121, avenue de Malakoff
F-75764 Paris Cédex 16 (FR)**

(72) Inventeur: **Bonnefoy, Jean
94 avenue Gambetta
F-75960 Paris Cedex 20 (FR)**

(74) Mandataire: **Denis, Hervé et al
BULL S.A. Industrial Property Department 25
avenue de la Grande-Armée
F-75016 Paris (FR)**

Courier Press, Leamington Spa, England.

EP 0 100 261 B1

Description

L'invention se rapporte à un dispositif de refroidissement par convection naturelle de composants électroniques ou de composants électriques et électroniques et à un appareil utilisant un tel dispositif.

Les composants électriques ou électroniques se composent généralement d'un support, d'une partie active de génération ou de traitement d'un signal électrique, et d'une surface prédéterminée pour l'évacuation des calories nécessairement produites dans la partie active. Ces trois parties se confondent pour une résistance électrique alors qu'elles sont nettement séparées pour des ensembles complexes tels que par exemple les boîtiers de transistors de puissance et les plaques d'interconnexion de dispositifs à circuits intégrés. Dans ces montages complexes concernés par l'invention, les éléments actifs sont fixés à un support et sont en liaison, avec un radiateur sans ou par l'intermédiaire du support. Le radiateur est une plaque de haute conductibilité thermique pourvue d'ailettes en vue d'accroître la surface effective de dissipation thermique pour le refroidissement de la partie active à laquelle le radiateur est relié.

Pour le refroidissement, on emploie habituellement des ventilateurs pour produire un courant d'air froid sur les radiateurs. Le refroidissement par convection naturelle est par contre rarement utilisé. La convection est par définition le mouvement d'un fluide dû à une variation de la température. La convection naturelle au niveau d'une surface chaude est ce mouvement qui se produit naturellement, c'est-à-dire dans brassage volontaire de l'air au niveau de cette surface. Dans l'air ambiant, la convection naturelle correspond à un mouvement ascentionnel, perpendiculaire à la surface chaude, des masses d'air échauffées au niveau de cette surface. L'expérience montre que la convection naturelle ne peut évacuer que de faibles densités superficielles de chaleur, de sorte qu'elle n'est ordinairement utilisée que pour le refroidissement d'éléments discrets de faible puissance.

Un perfectionnement au refroidissement par convection naturelle est décrit dans l'article de Thomas C. Reeves dans la revue "Machine Design" Vol. 29, No. 9, 1957, pages 84—93, intitulé "Thermal Design in Electronic Equipment". Cet article présente un dispositif de refroidissement par convection naturelle de composants électriques ou électroniques ayant différentes densités superficielles de dissipation thermique et montés sur des étages différents dans une enveloppe formant boîtier ou armoire, ouverte à ses deux extrémités haute et basse. Les composants sont classés en composants thermiquement actifs tels que tubes, transformateurs et résistances de puissance, et en composants thermiquement passifs tels que condensateurs, résistances de signal et dispositifs semiconducteurs, ordinairement sensibles à la chaleur. Si les composants sont placés dans un ordre quelconque, la chaleur d'un composant actif placé près d'un composant passif sensible à la chaleur en altère le fonctionnement. Le perfectionnement proposé par Reeves consiste donc à isoler les composants actifs des composants passifs et à placer ces derniers au bas de l'enveloppe. Les composants passifs sont ainsi tous refroidis à partir de l'air frais entrant par le bas de l'enveloppe et ne peuvent avoir leur fonctionnement altéré par l'un quelconque des composants actifs placés plus haut. Ce perfectionnement est donc une solution au problème des composants sensibles à la chaleur, refroidis par convection naturelle parmi des composants thermiquement actifs.

L'invention présente au contraire un perfectionnement visant à optimiser le refroidissement par convection naturelle de composants électriques ou électroniques.

Selon l'invention, un dispositif de refroidissement par convection naturelle de composants électroniques ou de composants électriques et électroniques verticalement alignés, ayant différentes densités superficielles de dissipation thermique et montés dans une enveloppe ouverte à ses deux extrémités haute et basse, est caractérisé en ce que lesdits composants sont disposés de bas en haut par ordre croissant de leur densité superficielle de dissipation thermique, en ce que certains d'entre eux sont des circuits intégrés, en ce que la densité superificielle de dissipation desdits circuits intégrés n'est pas la plus faible et en ce que le composant de plus forte densité superficielle de dissipation thermique se trouve à l'extrémité supérieure de l'enveloppe.

L'invention concerne aussi un appareil utilisant un tel dispositif de refroidissement.

Les caractéristiques et avantages de l'invention ressortiront de la description qui suit, faite en référence aux dessins annexés.

Dans les dessins:

la figure 1 est une vue schématique en coupe verticale d'un appareil mettant en oeuvre un exemple de réalisation de dispositif de refroidissement par convection naturelle conforme à l'invention; et

la figure 2 est une vue en coupe verticale selon la ligne II—II de l'appareil représenté sur la figure 1.

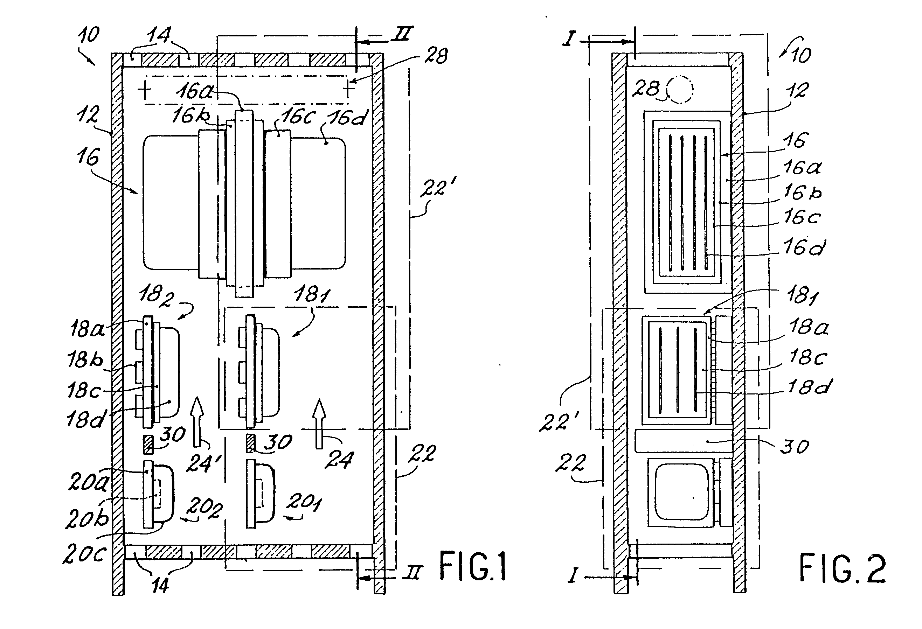

En référence aux figures 1 et 2, un appareil (10) se présente sous la forme d'un bâti parallélépipédique rectangle (12), dont les parois latérales sont fermées et dont les parois inférieure et supérieure présentent des ouies (14). L'appareil (10) est supposé être un appareil de traitement de signaux électriques incorporant un bloc d'alimentation en énergie électrique (16) et quatre composants (18₁, 18₂, 20₁, 20₂).

Le bloc (16) a une structure complexe, en ce sens qu'il comprend un support (16a) fixé au bâti (12), une partie active (16b) délivrant des tensions d'alimentation, et un radiateur (16c) pourvu d'ailettes (16d). Les deux composants (18) se présentent eux-mêmes sous la forme d'une plaque-support (18a) fixée au bâti (12) et comportant un réseau conducteur d'interconnexion d'une partie

2

active (18b) composée de dispositifs à circuits intégrés, et d'un radiateur (18c) pourvu d'ailettes (18d) pour former une surface de dissipation donnée en vue de dissiper l'énergie calorifique dégagée par la partie active (18b). De même, les deux composants (20) représentés constituent des boîtiers, composés d'un support (20a) pour un élément actif (20b) et d'une surface de dissipation (20c).

On définit la densité superficielle de dissipation thermique d'un composant par le rapport de l'énergie calorifique produite par la partie active du composant relativement à la grandeur de la surface de dissipation thermique formée par le radiateur éventuellement pourvu d'ailettes. On suppose ici par conséquence que la densité superficielle de dissipation thermique est faible pour les composants (20), moyenne pour les composants (18) et forte pour le composant (16).

Dans l'appareil (10), la surface de dissipation (20c) du composant $(20_1)$ est entourée par une enveloppe (22) représentée en trait tireté, ouverte à deux extrémités situées de part et d'autre de la surface de dissipation (20c). Dans l'exemple illustré, l'enveloppe (22) est formée par les parois correspondantes du bâti (12) et par la plaque-support (18a) du composant $(18_1)$ et ouverte à une extrémité par les ouïes (14) et à son extrémité opposée. Selon une caractéristique essentielle de l'invention, cette extrémité opposée comporte un moyen de plus forte densité superficielle de dissipation thermique. Ce moyen est ici formé par la surface de dissipation (18c) du composant $(18_1)$. Ainsi, la différence de température génératrice de la convection est établie dans ce cas entre les deux composants $(18_1)$ et $(20_1)$, de sorte que le mouvement représentatif de la convection s'établira suivant la flèche (24) pour créer dans l'enveloppe (22) un effet de cheminée dont le tirage s'effectuera par les ouïes (14) de la paroi inférieure (12a) et dont la grandeur sera proportionnelle au gradient de température entre les composants $(18_1)$ et $(20_1)$.

De même la surface de dissipation formée par le radiateur (18c) pourvu des ailettes (18d) du composant $(18_1)$ est entourée par une enveloppe (22') formée elle-même par le support (16a) du composant (16) et par les parois correspondantes du bâti (12), une extrémité étant ouverte sur les ouïes (14) de la paroi inférieure du bâti (12) par l'intermédiaire du composant $(20_1)$ et de son enveloppe (22) et l'autre extrémité étant ouverte sur les ouïes (14) de la paroi supérieure du bâti (12) et comportant un moyen à plus forte densité superficielle de dissipation thermique formé par le radiateur (16c) du bloc d'alimentation (16). En disposant les supports (16a, 18a, 20a) proches les uns des autres sensiblement dans un même plan avec les surfaces de dissipation correspondantes (16c, 18c, 20c) placées d'un même côté comme illustré, les deux enveloppes (22, 22') sont dans le prolongement l'une de l'autre en se recouvrant partiellement et constituent une même cheminée dans laquelle un courant d'air va se créer par convexion naturelle à cause des divers gradients thermiques suivant la flèche (24).

Il en est de même pour les composants (16), $(18_2)$ et $(20_2)$, dont les surfaces de dissipation (16c, 18c, 20c) sont proches l'une de l'autre et forment avec les parois du bâti (12) et les supports (18a, 20a) des composants $(18_2, 20_2)$ des cheminées (non référencées) en alignement l'une de l'autre et dans lesquelles un courant d'air selon la flèche (24') sera produit par l'effet des divers gradients thermiques suivant la flèche (24').

D'une manière générale, on comprend que l'invention consiste à disposer autour de la surface de dissipation une enveloppe ouverte à deux extrémités disposées de part et d'autre de la surface de dissipation et à placer à l'une de ces extrémités un moyen de plus forte densité superficielle de dissipation thermique afin de créer dans l'enveloppe un effet de cheminée. Dans l'exemple illustré, le moyen de plus forte densité superficielle de dissipation thermique est formé par les composants $(18_1, 18_2)$ pour les composants $(20_1, 20_2)$, et par le bloc d'alimentation (16) pour les composants $(18_1, 18_2)$. Mais il est évident que le moyen de plus forte densité superficielle de dissipation thermique peut être constitué par une source de chaleur (28) que l'on ajouterai aux composants de l'appareil (10), comme représenté par un trait tireté sur la figure 1 sous la forme d'une résistance électrique.

D'autre par, il est aussi évident que l'enveloppe pourrait être un capot associé à au moins un composant, au lieu d'être constituée par les parois du bâti (12) qui correspondent aux composants $(18_1, 20_1)$ et par les supports des composants voisins, comme dans l'exemple illustré. En outre, des plaques de liaison (30) pourraient être prévues entre supports voisins et entre en support et le bâti, ou même étendues en substitution de ceux-ci, pour que la paroi de l'enveloppe soit pratiquement uniforme.

**Revendications**

1. Dispositif de refroidissement par convexion naturelle de composants électroniques ou de composants électriques et électroniques (16, 18, 20) verticalement alignés, ayant différentes densités superficielles de dissipation thermique et montés dans une enveloppe (22) ouverte à ses deux extrémités haute et basse, caractérisé en ce que lesdits composants sont disposés de bas en haut par ordre croissant de leur densité superficielle de dissipation thermique, en ce que certains d'entre eux sont des circuits intégrés, en ce que la densité superficielle de dissipation desdits circuits intégrés n'est pas la plus faible et en ce que le composant de plus forte densité superficielle de dissipation thermique se trouve à l'extrémité supérieure de l'enveloppe (22).

2. Appareil (10), caractérisé en ce qu'il incorpore un dispositif de refroidissement tel que défini par la revendication 1.

**Patentansprüche**

1. Vorrichtung zur Kühlung von elektronischen oder elektrischen und elektronischen, sich senkrecht auf einer Linie befindlichen Bauteilen (16, 18, 20) durch natürliche Konvektion, wobei die Bauteile unterscheidliche Wärmeabgabedichten an der Oberfläche haben und in eine Umhüllung (22) eingebaut sind, die an ihrem oberen und unteren Ende geöffnet ist, dadurch gekennzeichnet, daß die Bauteile von unten nach oben in der Reihe der Zunahme der Oberflächen-Wärmeabgabedichte angeordnet sind, dadurch, daß einige davon integrierte Schaltungen sind, dadurch, daß die Oberflächen-Wärmeabgabedichte der integrierten Schaltungen nicht die niedrigste ist, und dadurch, daß sich das Bauteil mit der höchsten Oberflächen-Wärmeabgabedichte am oberen Ende der Umhüllung (22) befindet.

2. Gerät (10), dadurch gekennzeichnet, daß es eine wie in Anspruch 1 dargestellte Kühlungsvorrichtung enthält.

**Claims**

1. Natural convection cooling device for vertically aligned electronic or electrical and electronic components (16, 18, 20) having different surface densities of thermal dissipation and mounted in an envelope (22) open at its two top and bottom ends, characterised in that the said components are arranged from bottom to top by increasing order of their surface density of thermal dissipation, in that certain amongst them are integrated circuits, in that the surface density of dissipation of the integrated circuits is not the weakest and in that the component having the strongest surface density of thermal dissipation is located at the upper end of the envelope (22).

2. Apparatus (10) characterised in that it incorporates a cooling device as is defined by claim 1.

FIG.2

FIG.1